(19) Europäisches Patentamt
European Patent Office
Office européen des brevets

(11) EP 2 021 741 B1

(12) EUROPEAN PATENT SPECIFICATION

(45) Date of publication and mention
of the grant of the patent:
**22.08.2012 Bulletin 2012/34**

(51) Int Cl.:
*G01D 5/353* (2006.01)     *G01L 1/24* (2006.01)
*H01S 3/13* (2006.01)     *H01S 5/0687* (2006.01)

(21) Application number: **07736868.6**

(22) Date of filing: **25.05.2007**

(86) International application number:
**PCT/IT2007/000365**

(87) International publication number:
**WO 2007/138632 (06.12.2007 Gazette 2007/49)**

(54) **METHOD OF INTERROGATION OF A STATIC AND/OR DYNAMIC STRAIN SENSOR MAKING USE OF A LASER-FREQUENCY LOCKING METHOD, AND RELEVANT APPARATUS**

VERFAHREN ZUR ABFRAGE EINES STATISCHEN UND/ODER DYNAMISCHEN DEHNUNGSSENSORS UNTER VERWENDUNG EINES LASERFREQUENZVERRIEGELUNGSVERFAHRENS UND RELEVANTE VORRICHTUNG

PROCÉDÉ D'INTERROGATION D'UN CAPTEUR DE CONTRAINTE STATIQUE ET/OU DYNAMIQUE AU MOYEN D'UN PROCÉDÉ DE VERROUILLAGE DE FRÉQUENCE LASER ET APPAREIL CORRESPONDANT

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **26.05.2006 IT RM20060279**

(43) Date of publication of application:
**11.02.2009 Bulletin 2009/07**

(73) Proprietor: **Consiglio Nazionale delle Ricerche**
**00185 Roma (IT)**

(72) Inventors:
• **GAGLIARDI, Gianluca**
**I-00185 Roma (IT)**
• **FERRARO, Pietro**
**I-00185 Roma (IT)**
• **DE NATALE, Paolo**
**I-00185 Roma (IT)**
• **DE NICOLA, Sergio**
**I-00185 Roma (IT)**

(74) Representative: **Iannone, Carlo Luigi et al**
**Barzanò & Zanardo Roma S.p.A.**
**Via Piemonte 26**
**00187 Roma (IT)**

(56) References cited:
**US-A- 4 451 923     US-B1- 6 661 941**

• GAGLIARDI G ET AL: "Interrogation of fiber Bragg-grating resonators by polarization-spectroscopy laser-frequency locking" OPT. EXPRESS; OPTICS EXPRESS APR 2 2007, vol. 15, no. 7, 2 April 2007 (2007-04-02), pages 3715-3728, XP002453608 cited in the application
• CHOW J H ET AL: "Interrogation of a Passive Fiber Bragg Grating Resonator Sensor by Current Modulation of a Diode Laser" LEOS, 2005 IEEE ANNUAL MEETING CONFERENCE PROCEEDINGS SYDNEY, AUSTRALIA 23-27 OCT. 2005, PISCATAWAY, NJ, USA,IEEE, 23 October 2005 (2005-10-23), pages 802-803, XP010886804 ISBN: 0-7803-9217-5
• BALL G A ET AL: "POLARIMETRIC HETERODYNING BRAGG-GRATING FIBER-LASER SENSOR" OPTICS LETTERS, OSA, OPTICAL SOCIETY OF AMERICA, WASHINGTON, DC, US, vol. 18, no. 22, 15 November 1993 (1993-11-15), pages 1976-1978, XP000403408 ISSN: 0146-9592

EP 2 021 741 B1

**Description**

The present invention concerns a method of interrogation of a static and/or dynamic strain sensor making use of a laser frequency locking method and the relevant apparatus.

The invention is defined in the independent claims. Embodiments of the invention are set out in the dependent claims.

In particular, the method of the present invention utilises a particular type of feedback stabilisation to a fibre optic resonator, in particular constituted by two fibre Bragg gratings, utilising only the radiation reflected by said resonator and a detection system of the same radiation that is sensible to its polarisation, thus obtaining a signal that is also monitor of the mechanical and thermal state of the resonator. The invention realises therefore a method for the scanning of mechanical and thermal signals from a optical fibre resonator. The invention further concerns the relevant apparatuses for the frequency locking of a laser to an optical fibre resonator and for the interrogation of a sensor constituted by an optical fibre resonator.

High-precision and high-sensitivity laser spectroscopy as well as detection of gravitational waves and cavity quantum electrodynamics (QED) experiments strongly rely on precise stabilization of laser frequency to external optical resonators [1-3]. Over the last decades, this approach has been extensively used in a number of configurations, as efficient tool for reducing the frequency noise in free conditions before locking the laser to an absorption line or a secondary optical cavity [4,5], as well as for assuring the functioning of the unimodal laser [6].

Very recently, the use of a fibre Bragg-grating Fabry-Pérot (FBG) cavity as high-sensitivity mechanical sensor has been demonstrated similarly [7-9]. Several different methods have been implemented to obtain laser-frequency stabilization to an optical cavity, including side-of-fringe locking [10], transmission derivative spectroscopy [11], transmission polarisation spectroscopy, demonstrated by Hansch and Couillaud [12], and the Pound-Drever-Hall (PDH) sideband technique [13].

In a limited number of systems based on optical fibre, a scheme of this type that is sensible to the polarization has been successfully applied mostly to prevent laser-cavity mode-hopping and polarization-induced fading in interferometers, using weakly-birefringent fibres [6, 12].

The Hansch technique (**see also** US4451923 **on the same subject-matter**) has proven of limited applicability as yet, since it has been. used on resonators constituted by two conventional mirrors, requiring therefore a polarisation inside the cavity to induce the ellipticity necessary for the creation of the signal.

On one hand, the reflection polarisation spectroscopy method is attractive for its simplicity, since it is not necessary any modulation technique, as well as because it provides a dispersive-like signal that is ideal for the frequency correction being steep around the resonance with far-reaching wings. On the other hand, however, the main drawback is the need for a polarizing element between the mirrors, which may significantly degrade the cavity finesse, thus limiting its applicability range [12, 16].

This is confirmed also in the case of the very similar method proposed in US6661941. Although in this case a birefringence obtained by mechanical stresses is proposed.

This is the reason why the most popular scheme, which provides a suited frequency discriminator for the resonance and allow a large bandwidth of the servo circuit, is the above-mentioned PDH lock relying on laser radiofrequency modulation and phase-sensitive detection of the cavity-reflected power [14, 15]. The use of radio-frequency modulation is however very expensive and complex, and needs the use of an external radio-frequency oscillator (which may, by the way, increase considerably the apparatus dimensions).

An example of active sensors which uses similar concepts has been disclosed in Patent US 5 488 475. The sensor is a strain-like sensor that is extremely compact and has the additional advantage of a direct measurement already free from possible temperature variations (what in the FBG sensors can distort the shift measurement unless one has a further reference sensor). In fact, the insensitivity to temperature in the mentioned patent does not derive from the way the sensor is designed and/or interrogated, but essentially from the simple use of a HMF fibre stretch inside the sensible part of the designed strain sensor (which is a fibre-type sensor whose temperature insensitivity properties are well known since a long time). As for the functioning principle for the deformation detection, the above-mentioned sensor bases on an optical fibre laser wherein the same internal laser resonator (i.e. the one in which the emission and the amplification of the laser radiation take place, as in any other source of this type) can serve as sensible element. Apart from how the laser cavity is designed (i.e. whether there is inside a fibre grating or a doped fibre stretch), the fibre stretch constituting it is an "active" transducer, since each optical path variation thereof (caused e.g. by strain) will affect the working conditions of the same laser (for example the wavelength of the radiation emitted by the same source). This means that such variation is detectable directly at the output, and can be converted in a strain measurement if the necessary calibration factors are known. Once the relationship strain-wavelength (of one or more modes of the laser resonator) is known, the sensor produces already the desired information on strain, without the need of another source for the interrogation. This happens because the sensible element is the means in which the electromagnetic wave produced by the laser propagates and therefore is the means that determines the boundary conditions (resonator's modes, spacing and absolute frequency position). In this sense, the system of the US Patent is an active strain sensor type. It is needed however that the laser operates in extremely controlled conditions and that no external agent different from the observable quantity influences its activity. This aspect is by the way one of the limiting factors of the sensitivity of such device.

Chow J H et al., in "Interrogation of a Passive Fiber Bragg Grating Resonator Sensor by Current Modulation of a Diode Laser". LEOS, 2005 IEEE Annual Meeting Conference Proceedings Sydney, Australia 23-27 Oct. 2005, p. 802-803, disclose a method of interrogation of a fiber Bragg grating resonator sensor by current modulation of a diode laser and the relevant apparatus for strain detection.

It is object of the present invention to provide a laser-frequency locking to a fibre resonator which overcomes the drawbacks and solves the problems of the prior art.

It is further object of the present invention an apparatus for stabilising a laser making use of the locking method object of the present invention.

It is specific object of the invention an interrogation method of an optical sensor that makes use of the locking method object of the invention.

It is further specific object of the invention an apparatus for the detection of static and/or dynamic strains which overcomes the drawbacks, solves the problems of the prior art and improves considerably the performances.

It is **subject-matter** of the present invention a method for laser-frequency locking to a fibre resonator with induced birefringence, comprising the use of a laser external to the fibre optical resonator with induced birefringence, characterised in that the reflected radiation by the fibre optical resonator with induced birefringence is detected by means of a polarisation analyser and is used as reference signal for generating a correction signal which effectuates a feedback control of the laser.

Preferably according to the invention, the polarisation analyser is constituted by a polarising quarter-wave plate and a polarizing beam-splitter.

Preferably according to the invention, said correction signal is obtained by integration of the reference signal.

Preferably according to the invention, forward to the polarisation analyser and before the generation of the correction signal, the reflected radiation is detected in its transversal and longitudinal components, effectuating their analogical difference to obtain a reference signal substantially without offset.

According to the invention, said optical resonator with induced birefringence is constituted by two Bragg gratings inscribed in the fibre.

It is further specific subject-matter of the present invention a laser frequency-stabiliser apparatus, characterised in that it comprises a laser source, an optical fibre resonator with induced birefringence and a fibre beam separator for the separation of the radiation incident in the cavity of the resonator from the reflected radiation, the reflected radiation being analysed by a polarisation analyser and then detected by at least a photodiode, the detected radiation being used to obtain a correction signal that does a feedback control of the laser, so as to stabilise it.

Preferably according to the invention, the polarisation analyser is constituted by a polarising quarter-wave plate and a polarizing beam-splitter.

Preferably according to the invention, forward to the polarisation analyser the radiation is detected by two photodiodes in its transversal and longitudinal components, effectuating their analogical difference to obtain a reference signal substantially without offset.

Preferably according to the invention, the apparatus comprises an integrator that integrates the signal relevant to the detected radiation in order to obtain said correction signal.

Preferably according to the invention, the apparatus comprises, between the beam separator and the fibre optical resonator with induced birefringence, a polarising plate.

According to the invention, said fibre optical resonator with induced birefringence is constituted by two Bragg gratings inscribed in the fibre.

It is further specific subject-matter of the present invention a method of interrogation of a sensor constituted by a fibre optical resonator with induced birefringence, characterised in that it uses a laser according to the method of frequency locking that is subject-matter of the present invention, and in that the correction signal which effectuates the feedback control of the laser is the monitoring signal of the state of the sensor.

It is further specific subject-matter of the present invention an apparatus for the detection of static and dynamic strains, possibly due to temperature, comprising the components of the stabilisation apparatus that is subject-matter of the present invention, the optical resonator with induced birefringence being used as sensor and the correction signal being detected and used as monitoring signal of the sensor.

The invention will be now described by way of illustration but not by way of limitation, making reference to the figures of the attached drawings, wherein:

- figure 1 illustrates the reflected intensity spectra as a function of he deviation from the Bragg wavelength $\lambda$-$\lambda_{B,x}$, calculated for an orientation angle $\theta$ equal to 20° (solid line) and 0° (dotted line), with $\lambda_{B,x}$ = 1,5606 nm, $n_{B,x}$ = 1,45,

$\delta n_x$ = 1,8 × 10-4, $n_{B,y}$ - $n_{B,x}$ = 3 × 10-6, closed to the birefringence expected for an FBG), and $\delta n_y$ - $\delta n_x$ = 10-5;

- figure 2 shows a scheme of an embodiment of the apparatus according to the invention;
- figure 3 shows the reflection of the cavity, detected by a polarisation analyser (curve with two lobes) and the transmission (curve with an only positive peak) over a frequency range of the laser around the cavity resonance; in the upper graph, different cavity modes are shown in the cavity transmission over a wide range;
- figure 4 shows the effect of the correction of the stabilisation servo circuit on the signal of figure 3 when at its input the dispersive signal obtained according to the invention is sent, during a scanning of the laser frequency;
- figure 5 shows the FFT spectrum of the error signal during the locking: the grey line corresponds to the signal in free conditions;
- figure 6 shows the detection of a small dynamical strain in the FG cavity: the track corresponds to the Fast Fourier Transform (FFT) with 5 Hz resolution of the correction signal in the acoustic range when a peak-to-peak strain of 400 $n_\varepsilon$ (visible from the indicated peak) is applied to the fibre; the dashed line represents the background noise at 53 pε/√Hz;
- figure 7 shows the detection of a quasi-static strain in the FBG cavity as a function of time (15 s), for steps of 400 nε applied to the fibre by means of a piezoelectric transducer;
- figure 8 shows the correction signal response for a dynamical strain at very low frequency: the dashed line corresponds to a limited sensitivity to noise, which is equivalent to a strain of 600 pε/√Hz.

In the following description, one presents the method according to the invention, different with respect to prior art systems, for interrogating a Fibre Bragg Grating Fabry-Pérot resonator (FBGFP) with high finesse, extending the locking scheme of polarisation spectroscopy by Hansch et *al.* [12] for generating the discriminant signal which contains the resonance information of the cavity. With the interrogation scheme proposed by the present invention, the FBGFP can be suitably adopted as deformation sensor.

A result of the researches of the Applicant is the fact that the birefringence induced in the fibre during the inscription process of the FBG [17,18] leads to the same ellipticity effect of a common polariser in the cavity. One has therefore exploited this ellipticity specifically in order to come up with a locking technique and therefore for using the FBGFP as a dynamic and/or static strain sensor (or even temperature sensor).

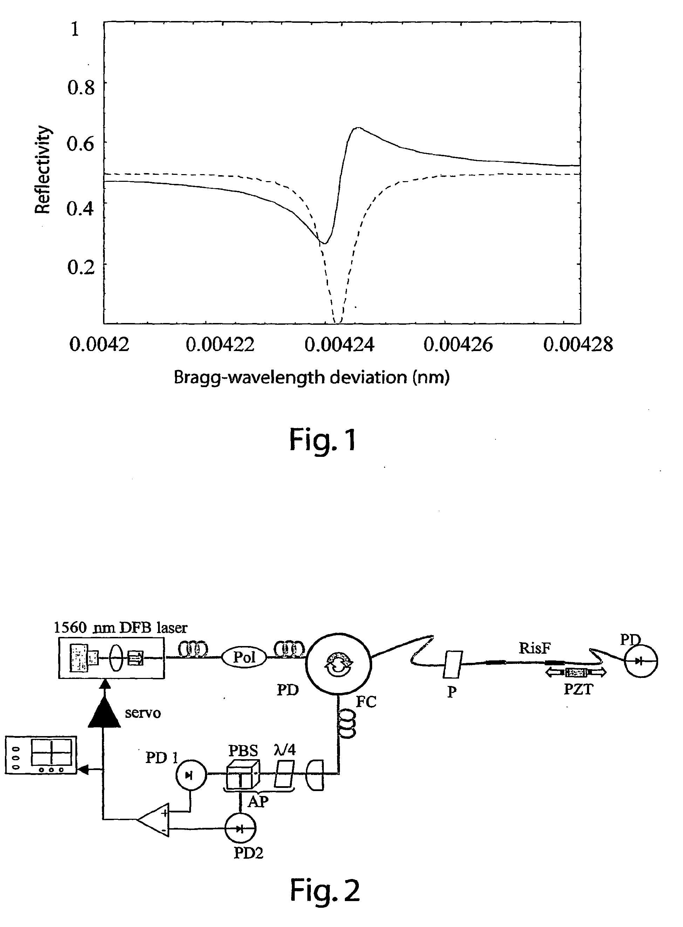

Making reference to figure 2, let us first consider the polarization-dependent complex response of a resonator made of two coupled, highly-reflective fibre Bragg-gratings by applying the equivalent-circuit approach introduced in [19]. In the following presentation of the invention principles, we assume two uniform, not apodized, Bragg gratings [20] of length $L$, spaced by a distance $L_d$ along the $z$ axis of a single-mode (SM) optical fibre, with different refractive-index modulations $\delta n_x$ and $\delta n_y$ along two transverse orthogonal directions $x$ and $y$ of the FBGFP frame. The main efficient indexes of the structure are supposed independent from the wavelength by the following simple law:

$$n_i(\lambda) = n_{B,i}\left[1 + a\left(\lambda - \lambda_{B,i} / \lambda_{B,i}\right)\right]$$

where $\lambda_{B,i}$ = $2p \cdot n_{B,i}$ and $n_{B,i}$ ($i=x,y$) are the Bragg wavelengths and the corresponding main refractive indexes, $p$ the period, and $a$ the linear dispersion coefficient.

The equivalent circuit of the FBGFP along the $i$-direction can be obtained replacing the Bragg gratings by two partially-reflecting mirrors with linear-wavelength-dependent amplitude reflection and transmission coefficients $r_i(\lambda)$ and $t_i(\lambda)$, as demonstrated in [18].

At a wavelength $\lambda$, the complex cavity reflection and transmission can be expressed in terms of $r_i(\lambda)$, and the following expressions can be derived for the cavity reflection coefficient $R_i(\lambda)$:

$$R_i(\lambda) = \frac{E_R^{(i)}}{E_{inc}^{(i)}} = \frac{r_i\left(1 - \exp\left(-j\phi_i(\lambda)\right)\right)}{1 - r_i^2 \exp\left(-j\phi_i(\lambda)\right)} \tag{1}$$

where $E_{inc}^{(i)}$, $E_R^{(i)}$ and $E_T^{(i)}$ are the $i$-component of the incident, reflected and transmitted field, respectively,

$\phi_i(\lambda) = 4\pi n_{B,i} L_r^{(i)}(\lambda) / \lambda$ , is the round-trip phase in the material of index $n_i(\lambda)$, and $L_r^{(i)}(\lambda)$ is the cavity equivalent length for the $i$-component of the field. According to the equivalent circuit, the two partially-reflecting mirrors are placed at an optical distance $n_{B,i} L_r^{(i)}(\lambda)$, therefore a distance slightly different from the fibre length between the two gratings. In a first-order approximation in λ, near the Bragg wavelengths $\lambda_{B,x} \approx \lambda_{B,y}$, the cavity equivalent length is given by the relation $L_r^{(i)}(\lambda) = L_F^{(i)} + \Delta L_r^{(i)} \lambda / \lambda_{B,i}$ , where $L_F^{(i)} = (1-a)(L_d + \tanh(k_i L)/k_i)$ determines the free-spectral-range (FS R) of the i-cavity and $\Delta L_r^{(i)} = L + L_d + p/2 - L_F^{(i)}$ is the slope of $L_r^{(i)}$ near the Bragg wavelength, and $k_i = \delta_{ni\pi/\lambda}$ is the i-component of the coupling coefficient of the grating.

This structure can be investigated by resonant laser radiation adjusted to a linear polarization state by a polarization retarder (P), and by analysing the state of polarization (SOP) of the reflected beam through a quarter-wave plate (λ/4) and a polarizing beam-splitter (PBS), which sets the laboratory frame. For a linear input field $E_{inc} = [E_{inc,\perp}$ $E_{inc,\parallel}]^T$, where $E_{inc,\perp}$ and $E_{inc,\parallel}$ are the electric field amplitudes perpendicular and parallel to P, the corresponding reflected intensities forward to the λ/4-PBS system (which constitutes a polarisation analyser AP) are given by:

$$I_{R,\perp}(\lambda) = \left| P_\perp \Re(\lambda/4)\Re(-\theta)R(\lambda)\Re(\theta)E_{inc} \right|^2$$

and

$$I_{R,\parallel}(\lambda) = \left| P_\parallel \Re(\lambda/4)\Re(-\theta)R(\lambda)\Re(\theta)E_{inc} \right|^2, \qquad (2)$$

respectively, where $P_\perp$, $P_\parallel$ are the Jones matrices of linear polarisers along the PBS axes, $\Re$(λ/4) is the λ/4-Jones matrix, $\Re$(θ) the rotation matrix and θ is the orientation of the FBGFP axes with respect to the laboratory frame. The last can be varied by acting on the input polarisation state via P.

Another theoretical model has been used by the Applicant, that for many aspects reproduces more accurately the experimental data. Such a method has been published in [21] .

Figure 1 illustrates the typical wavelength dependence of the orthogonal component of the normalized reflected intensity, obtained from equation (2) with θ = 0 (dashed) and θ = 20° (solid line), for two matched 13.5-dB Bragg gratings ($R \approx$ 95.5%) each 10-mm long and spaced by 130 mm.

An experimental arrangement actually used to test the polarization-spectroscopy interrogation scheme is shown in Fig. 2.

It must be clear here that by illustrating such an experimental arrangement one will introduce also components that are not fully needed for the implementation of the method but are particularly advantageous in the practice, and also specifications will be introduced that are to be understood by way of information and illustration of the particular test effectuated.

A distributed feedback (DFB) diode laser, emitting an average power of 10 mW at a wavelength of 1560 nm, is adopted as a coherent radiation source. The diode is driven by a low-noise current supply and is temperature-controlled by an active Peltier-stabilizer.

Laser radiation comes from a single-mode polarization-maintaining (PM) fibre, and its initial SOP is well determined by a linear fibre-coupled polariser that is indicated in the figure with the reference "Pol".

The beam is subsequently injected into an FBGFP resonator, referenced with "RisF" via an optical circulator FC (or fibre beam separator) to observe its transmission and reflection fields. The optical cavity reflectors used in the test have been two identical fibre-Bragg gratings, with manufacturer-certified reflectivity > 99.9 % at 1560.6± 0.1 nm, fabricated in the same single-mode fibre length with a center-to-center distance of about 13 cm. In fact, the overall quality factor of the cavity is also determined by the FBGs' spectral overlap and by their linewidth (about 0.6 nm), as the cavity mirrors might not be perfectly identical in this case.

In order to obtain a reliable estimate of this factor, a measurement of the resonances has been carried out with a narrow-line source, from which a finesse of around 200 comes out. The device's ends are fixed by two metallic mounts while a piezo-electric transducer PZT is placed between them to act in a controlled way on their distance. The whole system is thermally insulated in order to keep the length and the refractive index of the intra-cavity fibre stable during the measurement time. The SOP of the incident beam can be changed in a controlled manner thanks to a fibre-coupled polarization retarder P placed just before the cavity. The FBGFP transmitted power is monitored by a pig-tailed InGaAs PIN photodetector with fibre input, while the reflected field, through the circulator, propagates in the air and is detected by a 50-MHz-bandwidth pre-amplified InGaAs photodiode after being analysed by the analyser AP (it is here to be noted that the output in the free space is not needed, being possible to realise all in a fibre).

At these position, the amplitude signals obtained for proper angles between the laboratory frame set by the PBS and the FBGFP axes have a symmetric dispersive-like lineshape that crosses the zero exactly at the resonance. If one uses two photodiodes PD, as in figure 2, one can operate the analog difference between the orthogonal and the parallel components of the PBS which have a similar profile, crossing zero exactly at the center. In such a way, one still obtains a signal crossing zero at the center but with almost null offset.

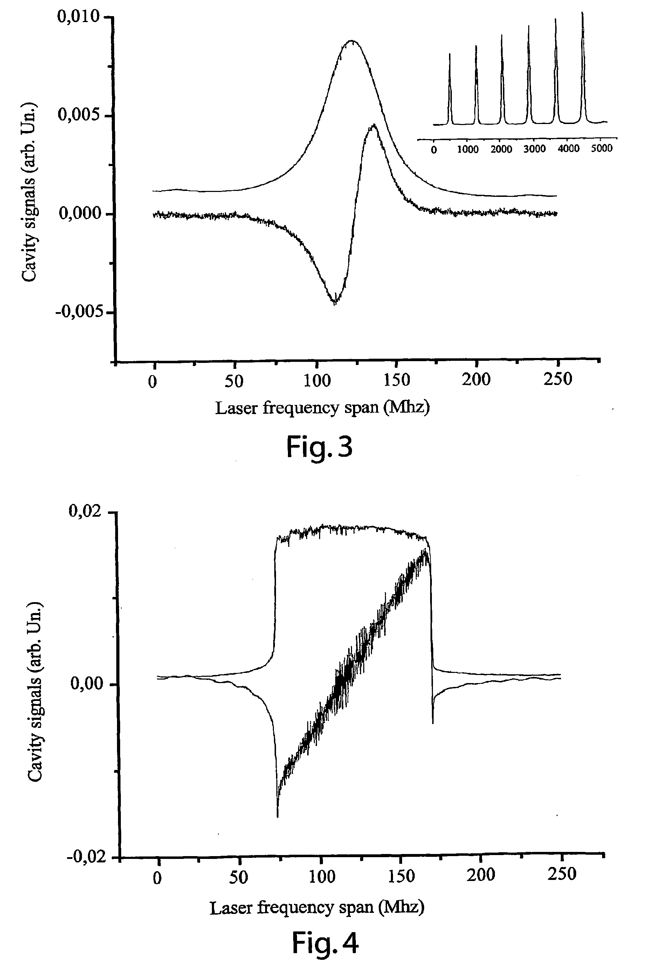

An example of this is shown in figure 3. As expected on the basis of the preliminary calculations carried out, the anisotropy resulting from the FBG-inscription process [20] is sufficient to observe a polarization-dependent cavity transfer function in qualitative agreement with numerical simulations.

This signal (obtained from the above-mentioned difference) serves as error signal of a purely-integrative servo circuit (for example a common integrator circuit) that corrects laser frequency fluctuations relative to the cavity and thus enables for active laser-locking on the resonance.

The signal produced by the servo is fed back to the laser through the current-driver external modulation input.

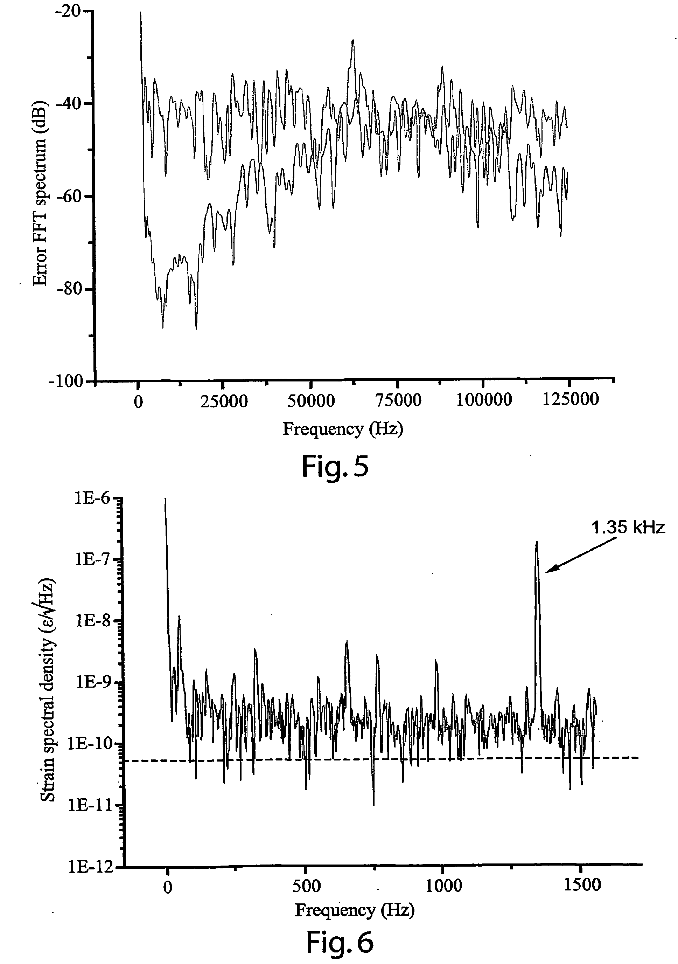

In figure 4, it is worth noting the servo action along a laser sweep over a cavity longitudinal mode. The results in the frequency domain (FFT spectrum) as shown in figure 5.

Comparing the polarization-spectroscopy based stabilization system with a PDH-type locking, using the same servo circuit and a sideband-modulation frequency of about 150 MHz, comparable performances between the two systems have been obtained.

In figure 5, in the FFT spectrum of the error signal in locking conditions, a reduction of frequency noise is highlighted of several tens of dB in the band from DC to 10 kHz. This involves, according to the invention, that the cycle correction signal can serve as extremely efficient monitor of the strain undergone by the inter-cavity fibre, i.e. by the sensible element, within this frequency band.

In figure 6, the correction signal in the time domain is represented on a scale of 20 s to track quasi-static load applied to the intra-cavity fibre, by means of voltage steps at the ends of the PZT.

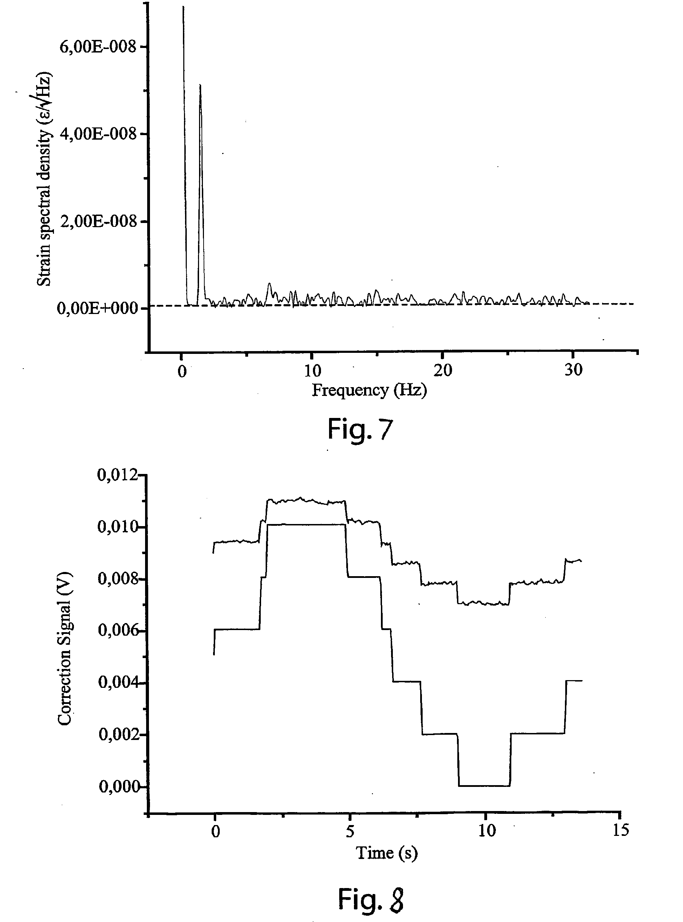

From figure 7 a noise-limited strain sensitivity as low as 53 $p\varepsilon/\sqrt{Hz}$ can be extracted for a peak signal-to-noise ratio of 70 dB, for an excitation of around 1 kHz.

In figure 8 the correction signal response for a dynamic strain at very low frequency is shown: the dotted line corresponds to a noise-limited sensitivity equivalent to the strain of 600 $p\varepsilon/\sqrt{Hz}$. A preliminary accurate calibration of all the test signals has been carried out with respect to its frequency and amplitude by measuring the cavity length modulation corresponding to same signal and using the RF sidebands as frequency markers (such an estimate is reliable since it does not have to take into account the mechanical transfer efficiency from PZT to the fibre).

One has therefore obtained for the first time, according to the invention, a static and dynamic tracking system with very wide dynamics (thanks to the locking of the laser frequency to the resonator's peaks) on a fibre resonators by exploiting only the birefringence that is present on it, without the addition of specific elements but only thanks to the spontaneous anisotropy effects, which are due in the specific case to the inscription of the two Bragg gratings.

The analysis of this birefringence on the beam coming back from the cavity produces a symmetrical signal that works as reference for a common integrative locking electronic circuit. The last allows keeping the laser emission wavelength constantly and actively locked to the cavity resonance peaks. Therefore the locking system itself provides information on the mechanical state of the intra-cavity fibre. In particular, the signal steering the circuit and the signal consequently produced by it can provide directly a measure of the applied strain.

It is to be noted that using such a system one detects at the same time all the disturbance frequencies (comprising for example those of the hearable sound or the ultrasonic ones).

It is possible to theoretically derive the formula for obtaining the sensor response as a function of strain (or temperature or other), or this can be easily measured, providing a calibration factor of the system. In order to obtain it analytically, it is possible to simulate (as done in the above theoretical introduction) the "error" signal and extract the value of the slope in the linear stretch around at its zero (i.e. the resonance). This provides the calibration in terms of error signal deformation.

In order to pass to the correction signal (the one which is used at the end as monitor of both static and dynamic strain), instead, the above-mentioned error factor has to be multiplied for the response of the integrative circuit that does the locking (the last is more reasonably derived experimentally, owing to the fact that it is an immediate measure).

In the practice, it is simple and effective to measure the amplitude of the error signal directly at the exit of the detectors placed in reflection positions and then derive the error signal, once known the servo response.

The most immediate method for obtaining the response inside the whole sensor-system consists in stressing the cavity fibre with a known signal and measuring the response only once.

The interrogation system and the sensor according to the invention has a threefold advantage: 1) the birefrin-

EP 2 021 741 B1

gence effect is such as to create, in reflection, an ellipticity effect on the laser beam that can be detected by a simple polarisation analyser (i.e. a polarising plate and a polarisation filter AP); 2) there is no need of an element internal to the resonant cavity that induces a birefringence useful to generate the "locking" signal: this would modify inevitably the resonator quality; 3) the combination of method and resonant-cavity sensor acts as very effective strain measurer.

The system according to the invention allows to use the fibre between the two FBG even as a most sensible strain and temperature sensor, since each stress results in a shift of the resonances of the resonator and therefore in a variation of the error signal amplitude (or of the result of its frequency integration) used for the active control of the laser-resonator locking. After a suited calibration, obtainable with great accuracy only from a preliminary measurement using a radiofrequency signal (therefore very accurate) as a reference, the system is ready for the measurement, with limits that are lower than nɛ/√Hz in quasi-static and acoustic condition (what is not trivial for the traditional sensors).

Essentially, the locking scheme based on the _polarisation according to the invention extends in an unexpected way the idea of Hansch et al. [12] to an optical resonator based on two FBG, which exploits the optical birefringence induced in the fibre by the same grating inscription process.

The technique according to the invention proves able to effectively stabilise the laser frequency to the resonant modes of the cavity with satisfactory performances in terms of bandwidth, proving also a detection sensitivity below the nɛ of dynamical deformations that act on the intra-cavity fibre.

The approach according to the invention can be similarly applied to the stabilisation of fibre-laser frequency by using an external fibre Bragg grating resonator as reference, thanks to its spontaneous birefringence.

With respect to the approach that uses weakly birefringent fibres [6, 12], the method according to the invention does not use an optical fibre ring that acts as active means of a laser, but creates a real interrogation system using for the first time a resonator constituted by a fibre linear stretch containing two FBGs.

With respect to the PDH known solution, the method according to the present invention does not need any radio-frequency-modulation and the relevant apparatus results therefore more compact and economical, as well as simpler to realise.

Moreover, with respect to the sensor of the cited US Patent US 5 488 475, the sensor according to the invention is a passive sensor that does not utilise the cavity of the laser, but a remote cavity, interrogated by means of a method in any case most different from the present one.

In this sense, the system according to the present invention keep separate the interrogation sensor from the deformation sensor.

The fact of being able to use a distant cavity is very important in all the cases of systems of distant sensors which are suited to detect for example the buildings stability.

References

[1] R.F. Rafac et al., Phys. Rev. Lett. 85, 2462-2465 (2000)

[2] S. Kawamura et al., Science 256, 325-333 (1992)

[3] Q. Turchette et al., Phys. Rev. Lett. 75, 4710-4713 (1995)

[4] G. Hagel et al., Rev. Sci. Instrum. 76, 123101 (2005)

[5] A. Schoof et al., Opt. Lett. 26, 1562-1564 (2001)

[6] R.J. Forster and N. Langford, J. Opt. Soc. Am. B 14, 2083-2090 (1997)

[7] J.H. Chow et al., Opt. Lett. 30, 1923-1925 (2005)

[8] J.H. Chow et al., J. Lightwave Technol. 23, 1881-1889 (2005)

[9] G. Gagliardi et al., J. Opt. A 8, S507-S513 (2006).

[10] R.L. Barger, M.S. Sorem, and J.H. Hall, Appl. Phys. Lett. 22, 573 (1973)

[11] A.D. White, IEEE J. Quant. Electronic QE-1, 349 (1965)

[12] T.W. Hansch and B. Couillaud, Opt. Comm. 35, 441 (1980)

[13] R.W.P. Drever, J.L. Hall, F.V. Kowalski, J. Hough, G.M. Ford, A.J. Munley, and H. Ward, Appl. Phys. B 31, 97 (1983)

[14] M. Zhu and J.L. Hall, J. Opt. Soc. Am. B 10, 802-816 (1993).

[15] N.J. Frigo, A. Dandridge, and A.B. Tveten, Electron. Lett. 20, 319 (1984).

[16] M. de Angelis et al., Appl. Phys. B 62, 333-338 (1996).

[17] S.T. Oh, W. Han, U. Paek, Y. Chung, Opt. Express 12, 724 (2004)

[18] T. Erdogan and V. Mizrahi, J. Opt. Soc. Am. 11, 2100 (1994)

[19] A. Melloni, M. Floridi, F. Morichetti, and M. Martinelli, J. Opt. Soc. Am. A 20, 273-281 (2003)

[20] T. Erdogan, J. Lightwave Technol. 15, 1277-1294 (1997)

[21] G. Gagliardi et al., Opt. Express Vol. 15 No. 7, 3715-3728.

The present invention has been described for illustrative but not limitative purposes, according to its preferred embodiments, but it is to be understood that modifications and/or changes can be introduced by those skilled in the art without departing from the relevant scope as defined in the enclosed claims.

**Claims**

1. Method of interrogation of a sensor constituted by a fibre optical resonator with induced birefringence (RisF), wherein it uses a laser locked to the optical fibre resonator with induced birefringence (RisF), and:

   - the fibre optical resonator (RisF) is constituted by two Bragg gratings inscribed in the fibre and having a birefringence induced by the inscription process; the method being **characterised in that**:
   - the reflected radiation by the fibre optical resonator with induced birefringence (RisF) is detected by means of a polarisation analyser (AP) and is used as reference signal for generating a correction signal which effectuates a feedback control of the laser, so as to stabilise it, and
   - said correction signal which applies the feedback control of the laser is the monitoring signal of the state of the sensor (RisF).

2. Method according to claim 1, **characterised in that** it is used a an optical resonator (RisF) constituted by two Bragg gratings inscribed in a single-mode (SM) optical fibre.

3. Apparatus for the detection of static and dynamic strains, possibly due to temperature, comprising:

   - a laser source,
   - an optical fibre resonator (RisF) constituted by
   - two Bragg gratings inscribed in the fibre and having a birefringence induced by the inscription process and
   - a fibre beam separator (FC) for the separation of the radiation incident in the cavity of the resonator from the reflected radiation, wherein
   - the optical resonator with induced birefringence (RisF) is used as sensor,
   **characterised in that**:
   - the reflected radiation is analysed by a polarisation analyser (AP) and then detected by two photodiodes ($PD_1$, $PD_2$),
   - the detected radiation is used to obtain a correction signal that performs a feedback control of the laser, so as to stabilise it, and
   - the correction signal is detected and used as monitoring signal of the sensor.

4. Apparatus according to claim 3, **characterised in that** it is used a an optical resonator (RisF) constituted by two Bragg gratings inscribed in a single-mode (SM) optical fibre.

**Patentansprüche**

1. Verfahren zur Abfrage eines Sensors, gebildet durch einen faseroptischen Resonator mit induzierter Doppelbrechung (RisF), wobei es einen Laser verwendet, der mit dem faseroptischen Resonator mit induzierter Doppelbrechung (RisF) gekoppelt ist, und:

   - der faseroptische Resonator (RisF) durch zwei Bragg-Gitter gebildet wird, die in die Faser eingeschrieben sind und eine Doppelbrechung aufweisen, die durch den Einschreibeprozess induziert ist; wobei das Verfahren **dadurch gekennzeichnet ist, dass**
   - die reflektierte Strahlung durch den faseroptischen Resonator mit induzierter Doppelbrechung (RisF) mittels eines Polarisationsanalysators (AP) detektiert wird und als Referenzsignal zur Erzeugung eines Korrektursignals verwendet wird, das eine Regelung des Lasers bewirkt, um diesen zu stabilisieren, und
   - das Korrektursignal, welches die Regelung des Lasers anwendet, das Beobachtungssignal des Zustands des Sensors (RisF) ist.

2. Verfahren gemäß Anspruch 1, **dadurch gekennzeichnet, dass** es einen optischen Resonator (RisF) verwendet, der durch zwei Bragg-Gitter gebildet wird, die in einer optischen Einzelmoden-(SM)-Faser eingeschrieben sind.

3. Vorrichtung zur Detektion von statischen und dynamischen Dehnungen, möglicherweise aufgrund von Temperatur, umfassend:

   - eine Laserquelle,
   - einen faseroptischen Resonator (RisF), der gebildet wird durch
   - zwei Bragg-Gitter, die in der Faser eingeschrieben sind und eine durch den Einschreibeprozess induzierte Doppelbrechung aufweisen, und
   - einen Faserstrahlseparator (FC) für die Separation der Strahlung, die in den Hohlraum des Resonators einfällt, von der reflektierten Strahlung, wobei
   - der optische Resonator mit induzierter Doppelbrechung (RisF) als Sensor verwendet wird,
   **dadurch gekennzeichnet, dass**:
   - die reflektierte Strahlung durch einen Polarisationsanalysator (AP) analysiert und dann durch zwei Photodioden ($PD_1$, $PD_2$) detektiert wird,
   - die detektierte Strahlung verwendet wird, um ein Korrektursignal zu erhalten, das eine Regelung des Lasers ausführt, um diesen zu stabilisieren, und
   - das Korrektursignal detektiert und als Beobachtungssignal des Sensors verwendet wird.

4. Vorrichtung gemäß Anspruch 3, **dadurch gekennzeichnet, dass** sie als ein optischer Resonator (RisF) verwendet wird, der durch zwei Bragg-Gitter gebildet wird, die in einer optischen Einzelmoden-(SM)-Faser eingeschrieben ist.

**Revendications**

1. Procédé d'interrogation d'un capteur constitué par un résonateur optique à fibre à biréfringence induite (RisF), dans lequel il utilise un laser verrouillé sur le résonateur optique à fibre à biréfringence induite (RisF), et :

   - le résonateur optique à fibre (RisF) est constitué par deux réseaux de Bragg inscrits dans la fibre et ayant une biréfringence induite par le processus d'inscription ; le procédé étant **caractérisé en ce que**
   - le rayonnement réfléchi par le résonateur optique à fibre à biréfringence induite (RisF) est détecté au moyen d'un analyseur de polarisation (AP) et est utilisé comme signal de référence pour générer un signal de correction qui effectue une commande en rétroaction du laser, de manière à le stabiliser et
   - ledit signal de correction qui applique la commande en rétroaction du laser est le signal de surveillance de l'état du capteur (RisF).

2. Procédé selon la revendication 1, **caractérisé en ce qu'**il utilise un résonateur optique (RisF) constitué par deux réseaux de Bragg inscrits dans une fibre optique monomode (SM).

**3.** Appareil pour la détection de déformations statiques et dynamiques éventuellement dues à la température, comprenant :

- une source laser,
- un résonateur optique à fibre (RisF) constitué par
- deux réseaux de Bragg inscrits dans la fibre et ayant une biréfringence induite par le processus d'inscription et
- un séparateur de faisceau à fibre (FC) destiné à séparer le faisceau incident dans la cavité du résonateur du faisceau réfléchi, dans lequel
- le résonateur optique à biréfringence induite (RisF) est utilisé comme capteur,

**caractérisé en ce que** :

- le rayonnement réfléchi est analysé par un analyseur de polarisation (AP), puis détecté par deux photodiodes (PD$_1$, PD$_2$),
- le rayonnement détecté est utilisé pour obtenir un signal de correction qui exécute une commande en rétroaction du laser de manière à le stabiliser, et
- le signal de correction est détecté et utilisé comme signal de surveillance du capteur,

**4.** Appareil selon la revendication 3, **caractérisé en ce qu'**il utilise un résonateur optique (RisF) constitué par deux réseaux de Bragg inscrits dans une fibre optique monomode (SM).

Fig. 1

Fig. 2

Fig. 3

Fig. 4

Fig. 5

Fig. 6

Fig. 7

Fig. 8

## REFERENCES CITED IN THE DESCRIPTION

**Patent documents cited in the description**

- US 4451923 A
- US 6661941 B
- US 5488475 A

**Non-patent literature cited in the description**

- **CHOW J H et al.** Interrogation of a Passive Fiber Bragg Grating Resonator Sensor by Current Modulation of a Diode Laser. *LEOS, 2005 IEEE Annual Meeting Conference Proceedings Sydney, Australia,* 23 October 2005, 802-803
- **R.F. RAFAC et al.** *Phys. Rev. Lett.,* 2000, vol. 85, 2462-2465
- **S. KAWAMURA et al.** *Science,* 1992, vol. 256, 325-333
- **Q. TURCHETTE et al.** *Phys. Rev. Lett.,* 1995, vol. 75, 4710-4713
- **G. HAGEL et al.** *Rev. Sci. Instrum.,* 2005, vol. 76, 123101
- **A. SCHOOF et al.** *Opt. Lett.,* 2001, vol. 26, 1562-1564
- **R.J. FORSTER ; N. LANGFORD.** *J. Opt. Soc. Am. B,* 1997, vol. 14, 2083-2090
- **J.H. CHOW et al.** *Opt. Lett.,* 2005, vol. 30, 1923-1925
- **J.H. CHOW et al.** *J. Lightwave Technol.,* 2005, vol. 23, 1881-1889
- **G. GAGLIARDI et al.** *J. Opt. A,* 2006, vol. 8, S507-S513
- **R.L. BARGER ; M.S. SOREM ; J.H. HALL.** *Appl. Phys. Lett.,* 1973, vol. 22, 573
- **A.D. WHITE.** *IEEE J. Quant. Electronic QE-1,* 1965, 349
- **T.W. HANSCH ; B. COUILLAUD.** *Opt. Comm.,* 1980, vol. 35, 441
- **R.W.P. DREVER ; J.L. HALL ; F.V. KOWALSKI ; J. HOUGH ; G.M. FORD ; A.J. MUNLEY ; H. WARD.** *Appl. Phys. B,* 1983, vol. 31, 97
- **M. ZHU ; J.L. HALL.** *J. Opt. Soc. Am. B,* 1993, vol. 10, 802-816
- **N.J. FRIGO ; A. DANDRIDGE ; A.B. TVETEN.** *Electron. Lett.,* 1984, vol. 20, 319
- **M. DE ANGELIS et al.** *Appl. Phys. B,* 1996, vol. 62, 333-338
- **S.T. OH ; W. HAN ; U. PAEK ; Y. CHUNG.** *Opt. Express,* 2004, vol. 12, 724
- **T. ERDOGAN ; V. MIZRAHI.** *J. Opt. Soc. Am.,* 1994, vol. 11, 2100
- **A. MELLONI ; M. FLORIDI ; F. MORICHETTI ; M. MARTINELLI.** *J. Opt. Soc. Am. A,* 2003, vol. 20, 273-281
- **T. ERDOGAN.** *J. Lightwave Technol.,* 1997, vol. 15, 1277-1294
- **G. GAGLIARDI et al.** *Opt. Express,* vol. 15 (7), 3715-3728